(19) Europäisches Patentamt
European Patent Office
Office européen des brevets

(11) EP 4 806 585 A1

# (12) EUROPEAN PATENT APPLICATION
published in accordance with Art. 153(4) EPC

(43) Date of publication:
**16.09.2026 Bulletin 2026/38**

(21) Application number: **24889108.7**

(22) Date of filing: **06.11.2024**

(51) International Patent Classification (IPC):
***B24B 37/24*** *(2012.01)* ***H01L 21/321*** *(2006.01)*
***G01N 24/08*** *(2006.01)* ***C08G 18/32*** *(2006.01)*
***C08G 18/10*** *(2006.01)* ***C08G 101/00*** *(2006.01)*

(52) Cooperative Patent Classification (CPC):
**B24B 37/24; B24D 3/26; C08G 18/10; C08G 18/32; G01N 24/08; H10P 50/00; H10P 95/00;**
C08G 2101/00

(86) International application number:
**PCT/KR2024/017369**

(87) International publication number:
**WO 2025/100921 (15.05.2025 Gazette 2025/20)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **06.11.2023 KR 20230151838**

(71) Applicant: **Enpulse Co., Ltd.**
**Cheonan-si, Chungcheongnam-do 31044 (KR)**

(72) Inventors:
- **KIM, Younghwan**
  **Seongnam-si, Gyeonggi-do 13453 (KR)**
- **SEO, Jangwon**
  **Seongnam-si, Gyeonggi-do 13453 (KR)**
- **YOON, Jongwook**
  **Seongnam-si, Gyeonggi-do 13453 (KR)**
- **MOON, Suyoung**
  **Seongnam-si, Gyeonggi-do 13453 (KR)**
- **HONG, Taeil**
  **Seongnam-si, Gyeonggi-do 13453 (KR)**
- **MIN, Eungi**
  **Seongnam-si, Gyeonggi-do 13453 (KR)**

(74) Representative: **Dehns**
**10 Old Bailey**
**London EC4M 7NG (GB)**

## (54) POLISHING PAD AND METHOD FOR MANUFACTURING SEMICONDUCTOR DEVICE BY USING SAME

(57) A polishing pad according to one implementation comprises a polishing layer, which contains a urethane-based prepolymer and a curing agent, wherein, with respect to the polishing layer, a spin-lattice relaxation time (T1) and a spin-spin relaxation time (T2) measured using TD-NMR satisfy equations 1 and 2, respectively, and thus the performance of the polishing pad can be improved.

[Fig. 1]

510
520
400
600
300
100
200



Processed by Luminess, 75001 PARIS (FR)

## Description

### Technical Field

Embodiments relate to a polishing pad for use in a chemical mechanical planarization (CMP) process of semiconductor devices.

### Background Art

The chemical mechanical planarization (CMP) process in a process for preparing semiconductors refers to a step in which a semiconductor substrate such as a wafer is fixed to a head and brought into contact with the surface of a polishing pad mounted on a platen, and the platen and the head are relatively moved to planarize the irregularities on the surface of the semiconductor substrate.

In such a CMP process, a polishing pad is required to have stable physical properties because it greatly affects the surface processing quality of the semiconductor substrate. In particular, since the polishing rate of the CMP process may vary sensitively depending on the components contained in the polishing pad and their physical properties, it is necessary to optimize the components contained in the polishing pad and their physical properties.

The CMP process may be carried out several times in the process of preparing a semiconductor device. A semiconductor device comprises a plurality of layers, in which each layer comprises a complex and fine circuit pattern. In addition, in recent years, the sizes of individual chips of a semiconductor device have been reduced, and the pattern of each layer is evolving to be more complex and finer. Accordingly, in the process of preparing a semiconductor device, the purpose of the CMP process has been expanded not only for the purpose of planarizing the circuit wiring, but also for the separation of the circuit wiring and the application of improvement of the wiring surface, and the like. As a result, more sophisticated and reliable CMP performance is required.

[Prior Art Document]

(Patent Document 1) Korean Laid-open Patent Publication No. 2016-0027075

### Disclosure of Invention

### Technical Problem

The present inventors have discovered that when the spin-lattice relaxation time (T1) and the spin-spin relaxation time (T2) measured using TD-NMR for the polishing layer satisfy a specific relationship, the degree of crosslinking of the polymer is controlled, thereby enhancing the performance of the polishing pad.

Accordingly, an object of the embodiment is to provide a polishing pad that has excellent overall physical properties and performance while minimizing the occurrence of defects and scratches during a CMP process.

### Solution to Problem

According to an embodiment, there is provided a polishing pad, which comprises a polishing layer comprising a urethane-based prepolymer and a curing agent, wherein the polishing layer satisfies the following Relationships 1 and 2.

$$\text{[Relationship 1]} \qquad T1 \leq 100 \text{ ms}$$

$$\text{[Relationship 2]} \qquad T2 \geq 0.21 \text{ ms}$$

In Relationships 1 and 2, T1 is the spin-lattice relaxation time measured at 25°C using TD-NMR, and T2 is the spin-spin relaxation time measured at 25°C using TD-NMR.

According to another embodiment, there is provided a process for preparing a semiconductor device, which comprises polishing the surface of a semiconductor substrate using the polishing pad.

### Advantageous Effects of Invention

In a polishing pad according to an embodiment, which comprises a polishing layer comprising a urethane-based prepolymer and a curing agent, the spin-lattice relaxation time (T1) and the spin-spin relaxation time (T2) measured using

TD-NMR for the polishing layer satisfy the above Relationships 1 and 2, respectively. As a result, the degree of crosslinking of the polymer is controlled, thereby enhancing the performance of the polishing pad. In the polishing pad according to the embodiment, the spin-lattice relaxation time (T1) and the spin-spin relaxation time (T2) are controlled using TD-NMR as described above; thus, it is possible to minimize the occurrence of defects and scratches during a CMP process while maintaining excellent overall physical properties and performance of the polishing pad.

## Brief Description of Drawings

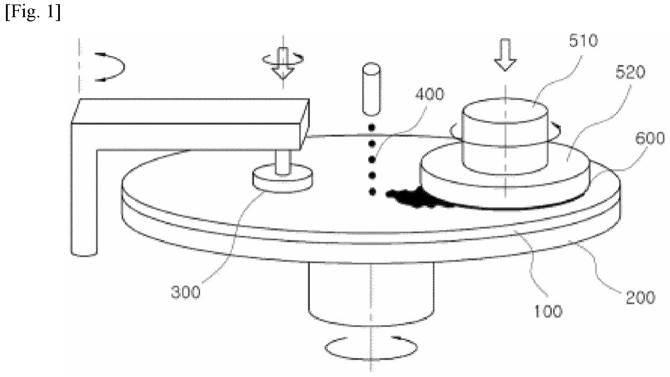

Fig. 1 schematically illustrates the process for manufacturing a semiconductor device according to an embodiment.

(Reference numeral of the drawings - 100: polishing pad, 200: platen, 300: conditioner, 400: polishing slurry, 510: polishing head, 520: carrier, 600: semiconductor substrate (wafer))

## Best Mode for Carrying out the Invention

Hereinafter, the present invention will be described in detail with reference to embodiments. The embodiments are not limited to what has been disclosed below. The embodiments may be modified into various forms as long as the gist of the invention is not altered.

In this specification, terms referring to the respective components are used to distinguish them from each other and are not intended to limit the scope of the embodiment. In addition, in the present specification, a singular expression is interpreted to cover a plural number as well unless otherwise specified in the context.

Throughout the present specification, when a part is referred to as "comprising" an element, it is understood that other elements may be comprised, rather than other elements are excluded, unless specifically stated otherwise.

In the present specification, when one component is described to be formed on/under another component or connected or coupled to each other, it covers the cases where these components are directly or indirectly formed, connected, or coupled through another component. In addition, it should be understood that the criterion for the terms on and under of each component may vary depending on the direction in which the object is observed.

All numerical ranges related to the physical properties, dimensions, and the like of a component used herein are to be understood as being modified by the term "about," unless otherwise indicated.

In the numerical range that limits the size, physical properties, and the like of components described in the present specification, when a numerical range limited with the upper limit only and a numerical range limited with the lower limit only are separately exemplified, it should be understood that a numerical range combining these upper and lower limits is also encompassed in the exemplary scope of the invention.

## Polishing pad

The polishing pad according to an embodiment comprises a polishing layer comprising a urethane-based prepolymer and a curing agent, wherein the polishing layer satisfies the following Relationships 1 and 2.

$$\text{[Relationship 1]} \qquad T1 \leq 100 \text{ ms}$$

$$\text{[Relationship 2]} \qquad T2 \geq 0.21 \text{ ms}$$

In Relationships 1 and 2, T1 is the spin-lattice relaxation time measured at 25°C using TD-NMR, and T2 is the spin-spin relaxation time measured at 25°C using TD-NMR.

TD-NMR (time domain nuclear magnetic resonance) is a method that analyzes the relaxation time of protons as they absorb energy from radio frequency (RF) pulses and then release energy to return to their original state. The spin-lattice relaxation time (T1), which is the time it takes for 63% of the z-component of magnetization M to recover after the resonance pulse is applied, and the spin-spin relaxation time (T2), which is the time it takes for the x-y plane component of M to go from 100% to 37%, can be measured.

Specifically, the polishing layer satisfies the following Relationships 1 and 2.

$$\text{[Relationship 1]} \qquad T1 \leq 100 \text{ ms}$$

$$\text{[Relationship 2]} \qquad T2 \geq 0.21 \text{ ms}$$

In Relationships 1 and 2, T1 is the spin-lattice relaxation time measured at 25°C using TD-NMR, and T2 is the spin-spin relaxation time measured at 25°C using TD-NMR.

In an embodiment, T1 is 100 ms or less. For example, it may be 95 ms or less, 90 ms or less, 85 ms or less, or 80 ms or less, and 0 ms or more, 10 ms or more, 20 ms or more, 30 ms or more, 40 ms or more, 50 ms or more, 60 ms or more, or 70 ms or more, specifically, 0 ms to 100 ms, 0 ms to 95 ms, 0 ms to 90 ms, 0 ms to 85 ms, 10 ms to 100 ms, 20 ms to 100 ms, 30 ms to 100 ms, 40 ms to 100 ms, 50 ms to 100 ms, 60 ms to 100 ms, 10 ms to 95 ms, 20 ms to 95 ms, 30 ms to 95 ms, 40 ms to 95 ms, or 50 ms to 95 ms.

In an embodiment, T2 is 0.21 ms or more. For example, it may be 0.22 ms or more, 0.23 ms or more, 0.24 ms or more, or 0.25 ms or more, and 0.5 ms or less, 0.4 ms or less, 0.3 ms or less, 0.28 ms or less, 0.26 ms or less, 0.25 ms or less, or 0.24 ms or less, specifically, 0.21 ms to 0.5 ms, 0.21 ms to 0.4 ms, 0.21 ms to 0.3 ms, 0.22 ms to 0.5 ms, 0.22 ms to 0.4 ms, 0.22 ms to 0.3 ms, 0.23 ms to 0.5 ms, 0.23 ms to 0.4 ms, or 0.23 ms to 0.3 ms.

As T1 and T2 satisfy Relationships 1 and 2, respectively, it is possible to minimize the occurrence of defects and scratches during a CMP process while maintaining excellent overall physical properties and performance of the polishing pad.

In addition, the polishing pad may have a pad wear rate (PWR) of 40 μm/10 minutes or less when measured under the conditions of a platen rotation speed of 90 rpm, a conditioner rotation speed of 120 rpm, and a conditioner load of 6 psi at a deionized water (DIW) supplying rate of 150 ml/minute.

For example, the pad wear rate measured under the above conditions may be 40 μm/10 minutes or less, 38 μm/10 minutes or less, 36 μm/10 minutes or less, 35 μm/10 minutes or less, 34 μm/10 minutes or less, or 33 μm/10 minutes or less, and 10 μm/10 minutes or more, 20 μm/10 minutes or more, 25 μm/10 minutes or more, or 30 μm/10 minutes or more, specifically, 10 μm/10 minutes to 40 μm/10 minutes, 20 μm/10 minutes to 40 μm/10 minutes, or 25 μm/10 minutes to 38 μm/10 minutes.

In addition, when the polishing pad is used to polish the silicon oxide layer of a silicon wafer with a ceria slurry, the polishing rate (removal rate) according to the following Mathematical Equation 1 may be 1,500 Å/minute to 6,000 Å/minute.

Polishing rate (Å/min.) = difference in thickness before and after polishing (Å) / polishing time (min.) [Mathematical Equation 1]

For example, when the polishing pad is used to polish the silicon oxide layer of a silicon wafer with a ceria slurry, the polishing rate may be 1,500 Å/minute or more, 1,550 Å/minute or more, 1,600 Å/minute or more, 1,650 Å/minute or more, or 1,700 Å/minute or more, and 6,000 Å/minute or less, 4,500 Å/minute or less, 3,000 Å/minute or less, 2,500 Å/minute or less, 2,000 Å/minute or less, or 1,900 Å/minute or less, specifically, 1,500 Å/minute to 4,500 Å/minute, 1,550 Å/minute to 3,000 Å/minute, or 1,600 Å/minute to 2,500 Å/minute.

The polishing rate may be, for example, an average polishing rate. Specifically, the polishing rate may be measured after a silicon oxide layer is polished under a polishing load of 4.0 psi while the platen is rotated at a speed of 150 rpm for 60 seconds and a calcined ceria slurry is supplied onto the polishing pad at a rate of 250 ml/minute. In addition, the thickness measurement for calculating the polishing rate may be carried out by, for example, mounting the silicon wafer upon polishing on a spin dryer, washing it with purified water, drying it with nitrogen for 15 seconds, and using an optical interference thickness meter on the dried silicon wafer.

The polishing pad according to an embodiment comprises a polishing layer and a support layer. In addition, an adhesive layer may be interposed between the polishing layer and the support layer.

Hereinafter, each constituent layer will be described in more detail.

## Polishing layer

The polishing layer provides a polishing surface that is brought into contact with a semiconductor substrate in a CMP process and constitutes a top pad in the polishing pad. The polishing layer performs polishing while it is in contact with a semiconductor substrate in a CMP process.

In an embodiment, the polishing layer comprises a urethane-based prepolymer and a curing agent. Specifically, the polishing layer comprises a polyurethane-based resin, which is a reaction product of a urethane-based prepolymer and a curing agent, i.e., a cured product of the urethane-based prepolymer.

In another embodiment, the polishing layer comprises a urethane-based prepolymer, a curing agent, and a foaming agent. Specifically, the polishing layer comprises a reaction product of a urethane-based prepolymer, a curing agent, and a foaming agent, i.e., a porous polyurethane-based resin obtained from a composition in which the components are mixed.

The polishing layer may comprise a plurality of pores formed from the foaming agent.

The pores are present as dispersed in the polishing layer.

The average diameter of the pores may be, for example, 10 μm to 60 μm, 10 μm to 50 μm, 20 μm to 50 μm, 20 μm to 40 μm, 10 μm to 30 μm, 20 μm to 25 μm, or 30 μm to 50 μm.

In addition, the total area of the pores may be 30% to 60%, 35% to 50%, or 35% to 43%, based on the total area of the polishing layer. In addition, the total volume of the pores may be 30 to 70%, or 40 to 60%, based on the total volume of the polishing layer.

The polishing layer may have a content of chlorine (Cl) of 70,000 ppm or less when analyzed according to the IEC 62321-3-2 standard. For example, the content of chlorine (Cl) of the polishing layer as analyzed according to the IEC 62321-3-2 standard may be 65,000 ppm or less, 62,000 ppm or less, or 57,000 ppm or less, and 0 ppm or more, 100 ppm or more, 200 ppm or more, 1,000 ppm or more, 2,500 ppm or more, 5,000 ppm or more, 10,000 ppm or more, or 25,000 ppm or more, specifically, 0 ppm to 70,000 ppm, 100 ppm to 70,000 ppm, 1,000 ppm to 70,000 ppm, 2,500 ppm to 66,000 ppm, 5,000 ppm to 65,000 ppm, 10,000 ppm to 62,000 ppm, 25,000 ppm to 60,000 ppm. As the content of chlorine (Cl) in the polishing layer satisfies the above range, it is possible to minimize the occurrence of defects and scratches during a CMP process while maintaining excellent overall physical properties and performance of the polishing pad.

The polishing pad according to an embodiment may have a particle size of debris of 30 μm or less, 25 μm or less, 20 μm or less, 19 μm or less, 18 μm or less, or 17 μm or less, and 5 μm or more, 10 μm or more, or 15 μm or more.

Specifically, the debris may be formed during conditioning while supplying 300 cc/minute of deionized water under the conditions of a platen speed of 93 rpm, a conditioner load of 9 lbs., a conditioner speed of 64 rpm, and a sweep of 19 times/minute. The particle size of the debris may be an average particle size, i.e., a D50 particle size.

As a specific example, when the polishing pad is conditioned while deionized water is supplied at 300 cc/minute under the conditions of a platen speed of 93 rpm, a conditioner load of 9 lbs., a conditioner speed of 64 rpm, and a sweep of 19 times/minute, the D50 particle size of the polishing pad debris formed may be 30 μm or less.

As another specific example, when the polishing pad is conditioned while deionized water is supplied at 300 cc/minute under the conditions of a platen speed of 93 rpm, a conditioner load of 9 lbs., a conditioner speed of 64 rpm, and a sweep of 19 times/minute, the D50 particle size of the polishing pad debris formed may be 10 μm to 30 μm, 10 μm to 25 μm, or 10 μm to 18 μm.

In addition, the polishing pad according to an embodiment may have a zeta potential value of the debris to be measured within a certain numerical range.

For example, the zeta potential value of an aqueous solution of a pH of 5.5 containing the debris obtained by conditioning the polishing layer at a concentration of 0.01% by weight may be -20 mV or more, -10 mV or more, -5 mV or more, 0 mV or more, 5 mV or more, 7 mV or more, or 10 mV or more, and 40 mV or less, 30 mV or less, 20 mV or less, 15 mV or less, 10 mV or less, or 8 mV or less.

Specifically, the zeta potential value of the aqueous solution of the debris may be a positive value (+).

As a specific example, the zeta potential value of an aqueous solution of a pH of 5.5 containing the debris obtained by conditioning the polishing layer at a concentration of 0.01% by weight may be -10 mV to 30 mV. As another specific example, the zeta potential value of an aqueous solution of a pH of 5.5 containing the debris obtained by conditioning the polishing layer at a concentration of 0.01% by weight may be 7 mV to 15 mV. As another specific example, the zeta potential value of an aqueous solution of a pH of 5.5 containing the debris obtained by conditioning the polishing layer at a concentration of 0.01% by weight may be -10 mV to 8 mV.

c

The polishing layer may have a hardness of, for example, 30 Shore D or more, 40 Shore D or more, 50 Shore D or more, or 55 Shore D or more, and 80 Shore D or less, 70 Shore D or less, 65 Shore D or less, or 60 Shore D or less. As a specific example, the hardness of the polishing layer may be 50 Shore D to 80 Shore D, 55 Shore D to 80 Shore D, 50 Shore D to 65 Shore D, 55 Shore D to 70 Shore D, or 55 Shore D to 65 Shore D. The Shore D hardness may be measured by, for example, cutting the polishing layer into a thickness of 2 mm, a width of 5 cm, and a length of 5 cm, storing it at 25°C for 12 hours, and using a hardness tester for measurement.

The polishing layer may have a tensile strength of, for example, 5 $N/mm^2$ or more, 10 $N/mm^2$ or more, or 15 $N/mm^2$ or more, and 30 $N/mm^2$ or less, 25 $N/mm^2$ or less, or 20 $N/mm^2$ or less. As a specific example, the tensile strength of the polishing layer may be 5 $N/mm^2$ to 30 $N/mm^2$ or 15 $N/mm^2$ to 25 $N/mm^2$. The tensile strength may be measured by, for example, cutting the polishing layer into a thickness of 2 mm, a width of 1 cm, and a length of 4 cm, and performing a tensile test at a speed of 50 mm/minute using a universal testing machine (UTM).

The polishing layer may have an elongation of, for example, 50% or more, 70% or more, 90% or more, 106% or more, or 120% or more, and 300% or less, 250% or less, 200% or less, or 150% or less. As a specific example, the elongation of the polishing layer may be 50% to 300% or 90% to 150%. The elongation may be an elongation at break. The elongation may be measured by, for example, cutting the polishing layer into a thickness of 2 mm, a width of 1 cm, and a length of 4 cm, performing a tensile test at a speed of 50 mm/minute using a universal testing machine (UTM) to measure the maximum deformation length immediately before fracture, and obtaining the ratio of the maximum deformation length to the initial length in a percentage (%).

As a specific example, the polishing layer may have a hardness of 55 Shore D to 70 Shore D, a tensile strength of

15 N/mm$^2$ to 25 N/mm$^2$, and an elongation of 90% to 150%.

The polishing layer may have grooves on its surface for mechanical polishing. The grooves may have a depth, a width, and a spacing as desired for mechanical polishing, which is not particularly limited.

The polishing pad according to an embodiment comprises a urethane-based prepolymer.

A prepolymer generally refers to a polymer having a relatively low molecular weight wherein the degree of polymerization is adjusted to an intermediate level for the sake of conveniently molding a product in the process of producing the same. A prepolymer may be molded by itself or after a reaction with another polymerizable compound. For example, a prepolymer may be prepared by reacting an isocyanate compound with a polyol.

The isocyanate compound used in the preparation of the urethane-based prepolymer may be one selected from the group consisting of an aromatic diisocyanate, an aliphatic diisocyanate, an alicyclic diisocyanate, or combinations thereof.

The isocyanate compound may comprise, for example, one selected from the group consisting of toluene 2,4-diisocyanate (2,4-TDI), toluene 2,6-diisocyanate (2,6-TDI), naphthalene 1,5-diisocyanate, para-phenylene diisocyanate, tolidine diisocyanate, 4,4'-diphenylmethane diisocyanate, hexamethylene diisocyanate, dicyclohexylmethane diisocyanate, isophorone diisocyanate, and combinations thereof.

The polyol is a compound comprising at least two or more hydroxyl groups (-OH) per molecule. For example, it may comprise one selected from the group consisting of a polyether polyol, a polyester polyol, a polycarbonate polyol, a polycaprolactone polyol, and combinations thereof.

The polyol may comprise, for example, one selected from the group consisting of polytetramethylene ether glycol, polypropylene ether glycol, ethylene glycol, 1,2-propylene glycol, 1,3-propylene glycol, 1,2-butanediol, 1,3-butanediol, 2-methyl-1,3-propanediol, 1,4-butanediol, neopentyl glycol, 1,5-pentanediol, 3-methyl-1,5-pentanediol, 1,6-hexanediol, diethylene glycol, dipropylene glycol, tripropylene glycol, and combinations thereof.

The polyol may have a weight average molecular weight (Mw) of 100 g/mole to 3,000 g/mole. For example, the weight average molecular weight of the polyol may be 100 g/mole to 3,000 g/mole, 100 g/mole to 2,000 g/mole, or 100 g/mole to 1,800 g/mole.

According to an embodiment, the polyol may comprise a low molecular weight polyol having a weight average molecular weight (Mw) of 100 g/mole to 300 g/mole and a high molecular weight polyol having a weight average molecular weight (Mw) of 300 g/mole to 1,800 g/mole.

In addition, the urethane-based prepolymer may have a weight average molecular weight (Mw) of 500 g/mole to 3,000 g/mole. For example, the weight average molecular weight of the urethane-based prepolymer may be 500 g/mole to 2,500 g/mole, 1,000 g/mole to 2,000 g/mole, or 1,000 g/mole to 1,500 g/mole.

According to an embodiment, the isocyanate compound for the preparation of the urethane-based prepolymer may comprise an aromatic diisocyanate compound, and the aromatic diisocyanate compound, for example, may comprise 2,4-toluene diisocyanate (2,4-TDI) and 2,6-toluene diisocyanate (2,6-TDI). The polyol compound for the preparation of the urethane-based prepolymer may comprise polytetramethylene ether glycol (PTMEG) and diethylene glycol (DEG).

According to another embodiment, the isocyanate compound for the preparation of the urethane-based prepolymer may comprise an aromatic diisocyanate compound and an alicyclic diisocyanate compound. For example, the aromatic diisocyanate compound comprises 2,4-toluene diisocyanate (2,4-TDI) and 2,6-toluene diisocyanate (2,6-TDI), and the alicyclic diisocyanate compound comprises dicyclohexylmethane diisocyanate (H12MDI). The polyol compound for the preparation of the urethane-based prepolymer may comprise polytetramethylene ether glycol (PTMEG) and diethylene glycol (DEG).

The urethane-based prepolymer may have an isocyanate end group content (NCO%) of 5% by weight or more, 8% by weight or more, 9% by weight or more, or 10% by weight or more, and 15% by weight or less, 13% by weight or less, 12% by weight or less, or 11% by weight or less. For example, the urethane-based prepolymer may have an isocyanate end group content (NCO%) of 5% by weight to 15% by weight. As a specific example, the urethane-based prepolymer may have an isocyanate end group content (NCO%) of 8% by weight to 15% by weight, 9% by weight to 15% by weight, 8% by weight to 11% by weight, or 9% by weight to 10% by weight.

The isocyanate end group content (NCO%) of the urethane-based prepolymer may be designed by comprehensively adjusting the type and content of the isocyanate compound and the polyol compound for the preparation of the urethane-based prepolymer, the process conditions such as temperature, pressure, and time in the process for preparing the urethane-based prepolymer, and the type and content of the additives used in the preparation of the urethane-based prepolymer.

If the isocyanate end group content (NCO%) of the urethane-based prepolymer satisfies the above range, the reaction rate, reaction time, and final curing structure in the subsequent reaction between the urethane-based prepolymer and a curing agent can be adjusted in a way favorable to the polishing performance from the viewpoint of the use and purpose of a final polishing pad.

According to an embodiment, the urethane-based prepolymer may have an isocyanate end group content (NCO%) of 9% by weight to 15% by weight.

Within the above preferred range of isocyanate end group content (NCO%), T1 and T2 can be controlled by adjusting physical properties such as the degree of crosslinking of the polymer that constitutes the polishing layer. As a result, CMP performance can be optimized, and quality can be uniformly controlled.

If the NCO% of the urethane-based prepolymer is less than the above range, the electrical properties based on the chemically hardened structure in the polishing pad may be achieved such that the desired polishing performance in terms of polishing rate and flatness are not achieved, and there may be a problem in that the lifespan of the polishing pad is reduced due to an excessive increase in the pad cut rate. On the other hand, if the NCO% exceeds the above range, surface defects such as scratches and chatter marks on the semiconductor substrate may increase.

The curing agent is a compound for chemically reacting with the urethane-based prepolymer to form a final cured structure in the polishing layer. For example, it may comprise an amine compound or an alcohol compound. Specifically, the curing agent may comprise one selected from the group consisting of an aromatic amine, an aliphatic amine, an aromatic alcohol, an aliphatic alcohol, and combinations thereof.

According to an embodiment, the curing agent may comprise a non-chlorine-based curing agent that does not contain a chlorine component. For example, the content of the non-chlorine-based curing agent may be 50% by weight or more, 80% by weight or more, 90% by weight or more, 95% by weight or more, 97% by weight or more, 99% by weight or more, or 99.5% by weight or more, and 100% by weight or less or 99.5% by weight or less, as a specific example, 80% by weight to 100% by weight, 90% by weight to 100% by weight, or 80% by weight to 99.5% by weight, based on the total weight of the curing agent. In addition, the content of the chlorine-based curing agent may be 20% by weight or less, 10% by weight or less, 5% by weight or less, 1% by weight or less, 0.5% by weight or less, or 0.3% by weight or less, and 0% by weight or more, 0.1% by weight or more, 0.5% by weight or more, as a specific example, 0% by weight to 20% by weight, 0% by weight to 1% by weight, 0% by weight to 0.5% by weight, or 0.5% by weight to 20% by weight, based on the total weight of the curing agent.

The curing agent may be at least one selected from a solid phase curing agent and a liquid phase curing agent.

The solid phase curing agent may contain an active hydrogen group. The solid phase curing agent may contain an amine group ($-NH_2$) as an active hydrogen group.

In addition, the solid phase curing agent may be an ester compound containing two or more benzene rings. Specifically, the solid phase curing agent may comprise two or more of the ester groups in the molecule.

The solid phase curing agent may have a weight average molecular weight of, for example, 150 g/mole to 400 g/mole, 150 g/mole to 350 g/mole, 200 g/mole to 350 g/mole, 250 g/mole to 350 g/mole, or 300 g/mole to 350 g/mole. In addition, the solid phase curing agent may have a melting point (m.p.) of 100°C to 150°C, 100°C to 140°C, or 110°C to 130°C.

In an embodiment, the solid phase curing agent comprises at least one selected from the group consisting of 1,3-propanediol bis(4-aminobenzoate) (PDPAB), 4-(4-aminobenzoyl)oxyphenyl 4-aminobenzoate, 4-(4-aminobenzoyl)oxybutyl 4-aminobenzoate, 4-[4-(4-aminobenzoyl)oxy-3-methylbutoxy]butyl 4-aminobenzoate, and methylene bis-methylanthranilate (MBNA).

The liquid phase curing agent may contain an active hydrogen group. The liquid phase curing agent may contain at least one selected from the group consisting of an amine group ($-NH_2$), a hydroxyl group (-OH), a carboxylic acid group (-COOH), an epoxy group, and a combination thereof as an active hydrogen group. Specifically, it may contain an amine group ($-NH_2$).

In addition, the liquid phase curing agent may contain sulfur in the molecule. Specifically, it may contain two or more sulfur elements in the molecule.

The liquid phase curing agent may have a weight average molecular weight of 50 to 300, for example, 100 to 250, for example, 150 to 250, for example, 200 to 250.

In addition, the liquid phase curing agent may be liquid at room temperature. Alternatively, the liquid phase curing agent may have a boiling point (b.p.) of 160°C to 240°C, specifically 170°C to 240°C, more specifically 170°C to 220°C.

Examples of the liquid phase curing agent include at least one selected from the group consisting of 3,5-dimethylthio-2,6-diaminotoluene (DMTDA), 2,6-bis(methylthio)-4-methyl-1,3-benzenediamine, and N,N'-bis(sec-butylamino)diphenylmethane.

In addition, the curing agent may further comprise other curing agents in addition to the liquid phase curing agent and the solid phase curing agent. The additional curing agent may be, for example, at least one of an amine compound and an alcohol compound. Specifically, the additional curing agent may comprise at least one compound selected from the group consisting of an aromatic amine, an aliphatic amine, an aromatic alcohol, and an aliphatic alcohol.

For example, the additional curing agent may be at least one selected from the group consisting of diaminodiphenylmethane, diaminodiphenyl sulphone, m-xylylene diamine, isophoronediamine, ethylenediamine, diethylenetriamine, triethylenetetramine, polypropylenediamine, polypropylenetriamine, ethylene glycol, diethylene glycol, dipropylene glycol, butanediol, hexanediol, glycerin, and trimethylolpropane.

As a specific example, the curing agent may comprise at least one selected from the group consisting of 4,4'-methylenebis(2-chloroaniline) (MOCA), diethyltoluenediamine (DETDA), 3,5-dimethylthio-2,6-diaminotoluene

(DMTDA), 1,3-propanediol bis(4-aminobenzoate) (PDPAB), N,N'-bis(sec-butylamino)diphenylmethane, 2,6-bis(methylthio)-4-methyl-1,3-benzenediamine, 4-(4-aminobenzoyl)oxyphenyl 4-aminobenzoate, 4-(4-aminobenzoyl) oxybutyl 4-aminobenzoate, 4-[4-(4-aminobenzoyl)oxy-3-methylbutoxy]butyl 4-aminobenzoate, and methylene bis-methylanthranilate (MBNA).

The content of the curing agent may be 60 parts by weight or more relative to 100 parts by weight of the urethane-based prepolymer. For example, the content of the curing agent may be 62 parts by weight or more, 65 parts by weight or more, or 70 parts by weight or more, and 100 parts by weight or less, 95 parts by weight or less, 90 parts by weight or less, 85 parts by weight or less, 80 parts by weight or less, or 75 parts by weight or less, specifically, 62 parts by weight to 100 parts by weight or 65 parts by weight to 90 parts by weight, relative to 100 parts by weight of the urethane-based prepolymer.

Within the above preferred content range of the curing agent, T1 and T2 can be controlled by adjusting physical properties such as the degree of crosslinking of the polymer that constitutes the polishing layer. As a result, CMP performance can be optimized, and quality can be uniformly controlled.

In addition, the equivalent ratio of the urethane-based prepolymer and the curing agent may be 1:0.5 to 2. For example, the equivalence ratio of the urethane-based prepolymer and the curing agent may be 1:0.5 to 1.5, 1:0.5 to 1.0, or 1:0.6 to 1.2.

The foaming agent is a component for forming a pore structure in the polishing layer. It may comprise one selected from the group consisting of a solid phase foaming agent, a gas phase foaming agent, a liquid phase foaming agent, and combinations thereof.

According to an embodiment, the foaming agent may be a non-chlorine-based foaming agent that does not contain a chlorine component. In particular, it may not contain, or minimize, the use of a chlorine-based foaming agent component commonly used in the preparation of polishing pads, such as vinylidene chloride (VDC). For example, the content of the non-chlorine-based foaming agent may be 50% by weight or more, 80% by weight or more, 90% by weight or more, 95% by weight or more, 97% by weight or more, 99% by weight or more, or 99.5% by weight or more, and 100% by weight or less or 99.5% by weight or less, as a specific example, 80% by weight to 100% by weight, 90% by weight to 100% by weight, or 80% by weight to 99.5% by weight, based on the total weight of the foaming agent. In addition, the content of the chlorine-based foaming agent may be 20% by weight or less, 10% by weight or less, 5% by weight or less, 1% by weight or less, 0.5% by weight or less, or 0.3% by weight or less, and 0% by weight or more, 0.1% by weight or more, 0.5% by weight or more, as a specific example, 0% by weight to 20% by weight, 0% by weight to 1% by weight, 0% by weight to 0.5% by weight, or 0.5% by weight to 20% by weight, based on the total weight of the foaming agent.

The foaming agent may be at least one selected from a solid phase foaming agent comprising particles having a hollow structure, a liquid phase foaming agent using a volatile liquid, and an inert gas.

As an example, the solid phase foaming agent may comprise particles having a hollow structure that have been expanded by heat and adjusted in size. Such a solid phase foaming agent has the advantage of controlling the size of pores to be uniform as it is employed in the raw material in an already expanded form and has a uniform particle size.

In addition, the solid phase foaming agent may comprise expandable particles. The expandable particles are particles having a characteristic that can be expanded by heat or pressure. Their size in the final polishing layer may be determined by heat or pressure applied in the process of preparing the polishing layer. The expandable particles are employed in the raw material in a particle state that has not been already expanded. Their final size is determined when expanded by heat or pressure applied during the process of preparing the polishing layer.

The solid phase foaming agent may have an average particle size of 5 μm to 100 μm, specifically, 5 μm to 50 μm or 20 μm to 50 μm. The average particle size of the solid phase foaming agent may refer to the average particle size of expanded particles themselves when the solid phase foaming agent is particles employed in the raw material in an expanded state as described below. It may refer to the average particle diameter of particles after they are expanded by heat or pressure in the preparation process when the solid phase foaming agent is particles employed in the raw material in an unexpanded state as described below.

The solid phase foaming agent in the form of expandable particles may comprise a shell of a resin; and an expansion-inducing component encapsulated inside the shell. These expandable particles may be formed into a hollow structure by the vaporization of the encapsulated expansion-inducing component by heat during the preparation process.

For example, the shell may comprise a thermoplastic resin. The thermoplastic resin may be at least one selected from the group consisting of an acrylonitrile-based copolymer, a methacrylonitrile-based copolymer, and an acrylic copolymer.

The thickness of the shell may be, for example, 0.1 μm or more, 0.5 μm or more, 1 μm or more, 2 μm or more, or 3 μm or more, and 15 μm or less, 12 μm or less, or 10 μm or less, as a specific example, 2 μm to 15 μm.

The expansion-inducing component may comprise one selected from the group consisting of a hydrocarbon compound, a tetraalkylsilane compound, and combinations thereof. Specifically, the hydrocarbon may comprise one selected from the group consisting of ethane, ethylene, propane, propene, n-butane, isobutane, n-butene, isobutene, n-pentane, isopentane, neopentane, n-hexane, heptane, petroleum ether, and combinations thereof. The tetraalkylsilane

compound may comprise one selected from the group consisting of tetramethylsilane, trimethylethylsilane, trimethylisopropylsilane, trimethyl-n-propylsilane, and combinations thereof.

The solid phase foaming agent may comprise particles treated with an inorganic component. In an embodiment, the solid phase foaming agent may be one treated with silica ($SiO_2$) particles. The treatment of the solid phase foaming agent with an inorganic component can prevent aggregation between a plurality of particles. The solid phase foaming agent treated with an inorganic component may be different from the solid phase foaming agent that is not treated with an inorganic component in terms of the chemical, electrical, and/or physical properties of the surface of the foaming agent.

The commercial products of the solid phase foaming agent include Nouryon's 920DE20d70, 051DET40d25, and 051DET40d42 and Matsumoto's F-65DE, F-80DE, and FN-80SDE.

As a specific example, the foaming agent used in the polishing pad according to an embodiment comprises a solid phase foaming agent. The solid phase foaming agent may comprise at least one selected from the group consisting of an acrylonitrile-based copolymer, a methylmethacrylate-based copolymer, a methacrylonitrile-based copolymer, and an acrylic-based copolymer.

The content of the solid phase foaming agent may be 0.1 part by weight or more, 0.5 part by weight or more, or 1 part by weight or more, and 5 parts by weight or less, 3 parts by weight or less, or 2 parts by weight or less, relative to 100 parts by weight of the urethane-based prepolymer. As a specific example, the content of the solid phase foaming agent may be 0.1 part by weight to 5 parts by weight or 0.5 part by weight to 2 parts by weight, relative to 100 parts by weight of the urethane-based prepolymer.

In an embodiment, the polishing layer comprises a foaming agent, wherein the foaming agent comprises at least one selected from the group consisting of an acrylonitrile-based copolymer, a methyl methacrylate-based copolymer, a methacrylonitrile-based copolymer, and an acrylic-based copolymer. The content of the foaming agent may be 0.1 part by weight to 5 parts by weight relative to 100 parts by weight of the urethane-based prepolymer.

The type and content of the solid phase foaming agent may be designed according to the desired pore structure and physical properties of the polishing layer.

Meanwhile, the liquid phase foaming agent may be introduced during the mixing and reaction of the prepolymer and the curing agent to form pores. It does not participate in the reaction between the prepolymer and the curing agent. In addition, the liquid phase foaming agent is physically vaporized by heat generated during the mixing and reaction of the prepolymer and the curing agent to form pores.

The volatile liquid phase foaming agent may be liquid at 25°C while it does not react with an isocyanate group, an amide group, and an alcohol group. Specifically, the volatile liquid phase foaming agent may be selected from the group consisting of cyclopentane, n-pentane, cyclohexane, n-butyl acetate, bis(nonafluorobutyl)(trifluoromethyl)amine; and perfluoro compounds such as perfluorotributylamine, perfluoro-N-methylmorpholine, perfluorotripentylamine, and perfluorohexane. Commercially available products of the perfluoro compound include FC-40 (3M), FC-43 (3M), FC-70 (3M), FC-72 (3M), FC-770 (3M), FC-3283 (3M), and FC-3284 (3M).

In addition, the foaming agent may comprise a gas phase foaming agent. For example, the foaming agent may comprise a solid phase foaming agent and a gas phase foaming agent.

The gas phase foaming agent may comprise an inert gas. The gas phase foaming agent is fed while the urethane-based prepolymer and the curing agent are reacted in order to be used as a component to form pores.

The kind of the inert gas is not particularly limited as long as it is a gas that does not participate in the reaction between the urethane-based prepolymer and the curing agent. For example, the inert gas may comprise one selected from the group consisting of nitrogen gas ($N_2$), carbon dioxide gas ($CO_2$), argon gas (Ar), helium gas (He), and combinations thereof.

The type and content of the gas phase foaming agent may be designed according to the desired pore structure and physical properties of the polishing layer.

The inert gas may be fed in a volume of 10% to 30% based on the total volume of the composition. Specifically, the inert gas may be fed in a volume of 15% to 30% based on the total volume of the composition. Specifically, the gas phase foaming agent may be fed through a predetermined feeding line while the urethane-based prepolymer, the solid phase foaming agent, and the curing agent are mixed. For example, the feeding rate of the gas phase foaming agent is about 0.8 L/minute to about 2.0 L/ minute, about 0.8 L minute to about 1.8 L/ minute, about 0.8 L/ minute to about 1.7 L/ minute, about 1.0 L/ minute to about 2.0 L/ minute, about 1.0 L/ minute to about 1.8 L/ minute, or about 1.0 L/ minute to about 1.7 L/ minute.

The composition for preparing a polishing layer may further comprise other additives such as a surfactant and a reaction rate controlling agent. The names such as "surfactant" and "reaction rate controlling agent" are arbitrary names based on the main role of the substances. The respective substances do not necessarily perform only a function limited to the role defined by the names.

The surfactant is not particularly limited as long as it acts to prevent pores from coalescing and overlapping with each other. For example, the surfactant may comprise a silicone-based surfactant.

The surfactant may be employed in an amount of 0.2 part by weight to 2 parts by weight relative to 100 parts by weight of the urethane-based prepolymer. Specifically, the surfactant may be employed in an amount of 0.2 part by weight

to 1.9 parts by weight, 0.2 part by weight to 1.8 parts by weight, 0.2 part by weight to 1.7 parts by weight, 0.2 part by weight to 1.6 parts by weight, 0.2 part by weight to 1.5 parts, or 0.5 part by weight to 1.5 parts by weight, relative to 100 parts by weight of the urethane-based prepolymer. If the amount of the surfactant is within the above range, pores derived from the gas phase foaming agent can be stably formed and maintained in the mold.

The reaction rate controlling agent serves to promote or retard the reaction. A reaction promoter, a reaction retarder, or both may be used depending on the purpose. The reaction rate controlling agent may comprise a reaction promoter. For example, the reaction rate controlling agent may be at least one reaction promoter selected from the group consisting of a tertiary amine-based compound and an organometallic compound.

Specifically, the reaction rate controlling agent may comprise at least one selected from the group consisting of triethylenediamine, dimethylethanolamine, tetramethylbutanediamine, 2-methyl-triethylenediamine, dimethylcyclohexylamine, triethylamine, triisopropanolamine, 1,4-diazabicyclo(2,2,2)octane, bis(2-methylaminoethyl) ether, trimethylaminoethylethanolamine, N,N,N,N,N"-pentamethyldiethylenetriamine, dimethylaminoethylamine, dimethylaminopropylamine, benzyldimethylamine, N-ethylmorpholine, N,N-dimethylaminoethylmorpholine, N,N-dimethylcyclohexylamine, 2-methyl-2-azanorbornane, dibutyltin dilaurate, stannous octoate, dibutyltin diacetate, dioctyltin diacetate, dibutyltin maleate, dibutyltin di-2-ethylhexanoate, and dibutyltin dimercaptide. Specifically, the reaction rate controlling agent may comprise at least one selected from the group consisting of benzyldimethylamine, N,N-dimethylcyclohexylamine, and triethylamine.

The reaction rate controlling agent may be employed in an amount of 0.05 part by weight to 2 parts by weight relative to 100 parts by weight of the urethane-based prepolymer. Specifically, the reaction rate controlling agent may be employed in an amount of 0.05 part by weight to 1.8 parts by weight, 0.05 part by weight to 1.7 parts by weight, 0.05 part by weight to 1.6 parts by weight, 0.1 part by weight to 1.5 parts by weight, 0.1 part by weight to 0.3 part by weight, 0.2 part by weight to 1.8 parts by weight, 0.2 part by weight to 1.7 parts by weight, 0.2 part by weight to 1.6 parts by weight, 0.2 part by weight to 1.5 parts by weight, or 0.5 part by weight to 1 part by weight, relative to 100 parts by weight of the urethane-based prepolymer. If the reaction rate controlling agent is used in the above content range, the curing reaction rate of the prepolymer composition may be appropriately controlled to form a polishing layer having pores of a desired size and hardness.

The thickness of the polishing layer may be 0.8 mm to 5.0 mm, 1.0 mm to 4.0 mm, 1.0 mm to 3.0 mm, 1.5 mm to 2.5 mm, 1.7 mm to 2.3 mm, or 2.0 mm to 2.1 mm. Within the above range, the basic physical properties of a polishing pad can be sufficiently exhibited while the particle size variation between the upper and lower portions is minimized.

**Support layer**

The support layer constitutes a bottom pad and serves to support the polishing layer and to absorb and disperse an impact applied to the polishing layer. Thus, it can minimize damage and defects to the object to be polished during the polishing process using the polishing pad.

The support layer may comprise a nonwoven fabric or a suede, but it is not limited thereto.

In an embodiment, the support layer may be a resin-impregnated nonwoven fabric. The nonwoven fabric may be a fibrous nonwoven fabric comprising one selected from the group consisting of a polyester fiber, a polyamide fiber, a polypropylene fiber, a polyethylene fiber, and combinations thereof.

The resin impregnated in the nonwoven fabric may comprise a polyurethane resin, a polybutadiene resin, a styrene-butadiene copolymer resin, a styrene-butadiene-styrene copolymer resin, an acrylonitrile-butadiene copolymer resin, a styrene-ethylene-butadiene-styrene copolymer resin, a silicone rubber resin, a polyester-based elastomer resin, a polyamide-based elastomer resin, and combinations thereof.

The support layer may have a thickness of 0.3 mm or more or 0.5 mm or more, and 3 mm or less, 2 mm or less, or 1 mm or less. As a specific example, the thickness of the support layer may be 0.3 mm to 3 mm or 0.5 mm to 1 mm.

The support layer may have a hardness of 50 Asker C or more, 60 Asker C or more, or 70 Asker C or more, and 100 Asker C or less, 90 Asker C or less, or 80 Asker C or less. As a specific example, the hardness of the support layer may be 50 Asker C to 100 Asker C or 60 Asker C to 90 Asker C.

In addition, an adhesive layer may be interposed between the polishing layer (top pad) and the support layer (bottom pad).

The adhesive layer may comprise a hot melt adhesive. The hot melt adhesive may be at least one selected from the group consisting of a polyurethane resin, a polyester resin, an ethylene-vinyl acetate resin, a polyamide resin, and a polyolefin resin. Specifically, the hot melt adhesive may be at least one selected from the group consisting of a polyurethane resin and a polyester resin.

In addition, a double-sided adhesive tape may be laminated under the support layer. When it is applied to CMP equipment, it is attached to the platen for use once the release paper of the double-sided adhesive tape has been removed.

**Process for preparing a polishing pad**

The process for preparing a polishing pad according to an embodiment comprises preparing a composition for a polishing pad comprising a urethane-based prepolymer, a foaming agent, and a curing agent; injecting the composition for a polishing pad into a mold and curing it to prepare a polishing layer; and laminating the polishing layer with a support layer.

The specific types and contents of the urethane-based prepolymer, curing agent, and foaming agent are as exemplified above.

As a specific example, the foaming agent comprises a solid phase foaming agent, the solid phase foaming agent comprises at least one selected from the group consisting of an acrylonitrile-based copolymer, a methyl methacrylate-based copolymer, a methacrylonitrile-based copolymer, and an acrylic-based copolymer, and the curing agent comprises at least one selected from the group consisting of diethyltoluenediamine (DETDA), 3,5-dimethylthio-2,6-diaminotoluene (DMTDA), 1,3-propanediol bis(4-aminobenzoate) (PDPAB), N,N'-bis(sec-butylamino)diphenylmethane, 2,6-bis(methylthio)-4-methyl-1,3-benzenediamine, 4-(4-aminobenzoyl)oxyphenyl 4-aminobenzoate, 4-(4-aminobenzoyl)oxybutyl 4-aminobenzoate, 4-[4-(4-aminobenzoyl)oxy-3-methylbutoxy]butyl 4-aminobenzoate, and methylene bis-methylanthranilate (MBNA).

The composition for a polishing pad may be prepared by sequentially or simultaneously mixing a urethane-based prepolymer, a foaming agent, and a curing agent.

As an example, the step of preparing the composition for a polishing pad may be carried out by mixing a urethane-based prepolymer with a curing agent, followed by further mixing with a foaming agent, or by mixing the urethane-based prepolymer with the foaming agent, followed by further mixing with the curing agent.

As another example, a urethane-based prepolymer, a curing agent, and a foaming agent may be put into the mixing process substantially at the same time. If a foaming agent, a surfactant, and an inert gas are further added, they may be put into the mixing process substantially at the same time.

As another example, a urethane-based prepolymer, a foaming agent, and a surfactant may be mixed in advance, and a curing agent, or a curing agent with an inert gas, may be subsequently introduced.

The mixing initiates the reaction of the urethane-based prepolymer and the curing agents and uniformly disperses the foaming agent and the inert gas in the raw materials. In such an event, a reaction rate controlling agent may intervene in the reaction between the urethane-based prepolymer and the curing agent from the beginning of the reaction, to thereby control the reaction rate. Specifically, the mixing may be carried out at a speed of 1,000 to 10,000 rpm or 4,000 to 7,000 rpm. Within the above speed range, it may be more advantageous for the inert gas and the foaming agent to be uniformly dispersed in the raw materials.

In addition, the step of preparing the composition for a polishing pad may be carried out under the condition of 50°C to 150°C. If necessary, it may be carried out under vacuum defoaming conditions.

If the foaming agent comprises a solid phase foaming agent, the step of preparing the composition for a polishing pad may comprise mixing the urethane-based prepolymer and the solid phase foaming agent to prepare a first preliminary composition; and mixing the first preliminary composition and the curing agent to prepare a second preliminary composition.

The first preliminary composition may have a viscosity of about 1,000 cps to about 2,000 cps, for example, about 1,000 cps to about 1,800 cps, for example, about 1,000 cps to about 1,600 cps, for example, about 1,000 cps to about 1,500 cps at about 80°C.

If the foaming agent comprises a gas phase foaming agent, the step of preparing the composition for a polishing pad may comprise preparing a third preliminary composition comprising the urethane-based prepolymer and the curing agent; and feeding the gas phase foaming agent to the third preliminary composition to prepare a fourth preliminary composition. In an embodiment, the third preliminary composition may further comprise a solid phase foaming agent.

In an embodiment, the step of preparing a polishing layer comprises preparing a mold preheated to a first temperature; and injecting the composition for a polishing pad into the preheated mold and curing it; and post-curing the cured composition for a polishing pad under a second temperature condition higher than the preheating temperature.

In an embodiment, the temperature difference between the first temperature and the second temperature may be about 10°C to about 40°C, for example, about 10°C to about 35°C, for example, about 15°C to about 35°C. In an embodiment, the first temperature may be about 60°C to about 100°C, for example, about 65°C to about 95°C, for example, about 70°C to about 90°C. In an embodiment, the second temperature may be about 100°C to about 130°C, for example, about 100°C to 125°C, for example, about 100°C to about 120°C.

The step of curing the composition for a polishing pad at the first temperature may be carried out for about 5 minutes to about 60 minutes, for example, about 5 minutes to about 40 minutes, for example, about 5 minutes to about 30 minutes, for example, about 5 minutes to about 25 minutes.

The step of post-curing the composition for a polishing pad cured at the first temperature at the second temperature may be carried out for about 5 hours to about 30 hours, for example, about 5 hours to about 25 hours, for example, about 10 hours to about 30 hours, for example, about 10 hours to about 25 hours, for example, about 12 hours

to about 24 hours, for example, about 15 hours to about 24 hours.

Thereafter, the step of injecting the composition for a polishing pad into a mold and curing it may be carried out under the temperature condition of 60°C to 120°C and the pressure condition of 50 kg/m$^2$ to 200 kg/m$^2$.

In addition, the above preparation process may further comprise the steps of cutting the surface of a polishing pad thus obtained, machining grooves on the surface thereof, bonding it with a lower part, inspection, packaging, and the like. These steps may be carried out in a conventional manner for preparing a polishing pad.

As an example, the process for preparing a polishing pad may further comprise machining at least one side of the polishing layer. The step of machining at least one side of the polishing layer may comprise forming grooves on at least one side of the polishing layer; lathe turning at least one side of the polishing layer; and roughening at least one side of the polishing layer.

The grooves may comprise at least one of concentric circular grooves spaced apart from the center of the polishing layer at a certain interval; and radial grooves continuously connected from the center of the polishing layer to the edge of the polishing layer. The lathe turning may be carried out by cutting the polishing layer in a certain thickness using a cutting tool. The roughening may be carried out by machining the surface of the polishing layer with a sanding roller.

**Process for preparing a semiconductor device**

The process for preparing a semiconductor device according to another embodiment comprises polishing the surface of a semiconductor substrate using the polishing pad.

Specifically, the process for preparing a semiconductor device may comprise providing the polishing pad according to an embodiment; and relatively rotating the polishing surface of the polishing layer and the surface of a semiconductor substrate while they are in contact with each other to polish the surface of the semiconductor substrate.

Fig. 1 illustrates a process for preparing a semiconductor device using a polishing pad according to an embodiment. Referring to Fig. 1, once the polishing pad (100) according to an embodiment has been attached to a platen (200), a semiconductor substrate (600) as an object to be polished is disposed on the polishing pad (100). In such an event, the surface of the semiconductor substrate (600) to be polished is in direct contact with the polishing surface of the polishing pad (100). A polishing slurry (400) may be sprayed through a nozzle onto the polishing pad for polishing. The flow rate of the polishing slurry (400) supplied through the nozzle may be selected according to the purpose within a range of about 10 cm$^3$/minute to about 1,000 cm$^3$/minute. For example, it may be about 50 cm$^3$/minute to about 500 cm$^3$/minute, but it is not limited thereto.

Thereafter, the semiconductor substrate (600) and the polishing pad (100) rotate relatively to each other, so that the surface of the semiconductor substrate (600) is polished. In such an event, the rotation direction of the semiconductor substrate (600) and the rotation direction of the polishing pad (100) may be the same direction or opposite directions. The rotation speeds of the semiconductor substrate (600) and the polishing pad (100) may each be selected according to the purpose within a range of about 10 rpm to about 500 rpm. For example, it may be about 30 rpm to about 200 rpm, but it is not limited thereto.

The semiconductor substrate (600) mounted on the polishing head (510) is pressed against the polishing surface of the polishing pad (100) at a predetermined load to be in contact therewith, and the surface thereof may then be polished. The load applied to the polishing surface of the polishing pad (100) through the surface of the semiconductor substrate (600) by the polishing head (510) may be selected according to the purpose within a range of about 1 gf/cm$^2$ to about 1,000 gf/cm$^2$. For example, it may be about 10 gf/cm$^2$ to about 800 gf/cm$^2$, but it is not limited thereto.

In an embodiment, the semiconductor substrate (600) as an object to be polished may comprise an oxide layer, a tungsten layer, or a composite layer thereof. Specifically, the semiconductor substrate (600) may comprise an oxide layer, a tungsten layer, or a composite layer of an oxide layer and a tungsten layer. The composite layer of an oxide layer and a tungsten layer may be a multilayer film in which the tungsten layer is laminated on one side of the oxide layer or may be a single-layer film in which an oxide region and a tungsten region are mixed in a single layer. As the object to be polished has such a film substance, and, at the same time, the polishing pad has characteristics according to the embodiment, a semiconductor device fabricated according to the process for preparing a semiconductor device may have minimum defects.

In an embodiment, the process for preparing a semiconductor device may further comprise, in the step of polishing the object to be polished, supplying any one of a slurry for polishing an oxide layer and a slurry for polishing a tungsten layer; or sequentially supplying the slurry for polishing an oxide layer and the slurry for polishing a tungsten layer to the polishing surface.

For example, if the semiconductor substrate as an object to be polished comprises an oxide layer, the process for preparing a semiconductor device may comprise supplying a slurry for polishing an oxide layer. If the semiconductor substrate comprises a tungsten layer, the process for preparing a semiconductor device may comprise supplying a slurry for polishing a tungsten layer. If the semiconductor substrate comprises a composite layer of an oxide layer and a tungsten layer, the process for preparing a semiconductor device may comprise sequentially supplying a slurry for polishing an

oxide layer and a slurry for polishing a tungsten layer to the polishing surface. Here, depending on the process, the slurry for polishing an oxide layer may be supplied first and then the slurry for polishing a tungsten layer may be supplied later, or the slurry for polishing a tungsten layer may be supplied first and then the slurry for polishing an oxide layer may be supplied later.

In an embodiment, in order to maintain the polishing surface of the polishing pad (100) in a state suitable for polishing, the process for preparing a semiconductor device may further comprise processing the polishing surface of the polishing pad (100) with a conditioner (300) simultaneously with polishing the semiconductor substrate (600).

In the polishing pad according to the embodiment, the spin-lattice relaxation time (T1) and the spin-spin relaxation time (T2) are controlled using TD-NMR; thus, it is possible to minimize the occurrence of defects and scratches during a CMP process while maintaining excellent overall physical properties and performance of the polishing pad.

**Mode for the Invention**

Hereinafter, the above description is explained in detail by the following examples. However, the scope of the embodiment is not limited to the following examples.

**Example 1: Preparation of a polishing pad**

(1) Preparation of a urethane-based prepolymer

A four-necked flask was charged with toluene diisocyanate (TDI), dicyclohexylmethane diisocyanate (H12MDI), polytetramethylene ether glycol (PTMEG), and diethylene glycol (DEG), followed by reaction thereof at 80°C for 3 hours, thereby preparing a urethane-based prepolymer having an isocyanate end group content (NCO%) of 10%.

(2) Preparation of a polishing pad

A casting machine equipped with tanks and feeding lines for the raw materials such as the urethane-based prepolymer, a curing agent, and an inert gas was provided. Specifically, the urethane-based prepolymer prepared in step (1), a curing agent (4,4'-methylenebis(2-chloroaniline), MOCA), a solid phase foaming agent (average particle size: 20 μm), an inert gas ($N_2$), and a silicone-based surfactant (manufacturer: Evonik) were each charged to the tanks. In such an event, 70 parts by weight of the curing agent, 5 parts by weight of the surfactant, and 5 parts by weight of the solid phase foaming agent were added to 100 parts by weight of the urethane-based prepolymer, and inert gas was supplied at a rate of 2 L/minute.

Thereafter, the raw materials were stirred while they were fed to the mixing head at constant rates through the respective feeding lines (mixing head rotation speed: approximately 5,000 rpm). A mold (1,000 mm × 1,000 mm × 3 mm) was prepared and preheated at a temperature of 80°C. The stirred mixture was injected into the mold and reacted to obtain a molded article in the form of a solid cake. Thereafter, the top and bottom of the molded article were each ground to obtain a polishing layer for a top pad.

Thereafter, the polishing layer was subjected to surface milling and groove-forming steps and laminated with a support layer for a bottom pad by a hot melt adhesive, thereby preparing a polishing pad. In such an event, a double-sided adhesive tape (442JS, 3M) was laminated under the support layer so that it could be attached to the platen of CMP equipment.

Examples 2 to 6: **Preparation of a polishing pad**

Polishing pads were each prepared in the same manner as in Example 1, except that the components and contents were changed as shown in Table 1 below, respectively.

**Comparative Examples 1 to 6: Preparation of a polishing pad**

Polishing pads were each prepared in the same manner as in Example 1, except that the components and contents were changed as shown in Table 2 below, respectively.

[Table 1]

| | | Ex. 1 | Ex. 2 | Ex. 3 | Ex. 4 | Ex. 5 | Ex. 6 |
|---|---|---|---|---|---|---|---|
| Urethane-based prepolymer | NCO% (%) | 10 | 10 | 10 | 10 | 10 | 10 |
| | Content (part by weight) | 100 | 100 | 100 | 100 | 100 | 100 |

(continued)

| | | Ex. 1 | Ex. 2 | Ex. 3 | Ex. 4 | Ex. 5 | Ex. 6 |
|---|---|---|---|---|---|---|---|
| Curing agent (part by weight) | MOCA | 70 | 80 | 86 | - | - | - |
| | DMTDA | - | - | - | 70 | 80 | 86 |
| Surfactant (part by weight) | | 5 | 5 | 5 | 5 | 5 | 5 |
| Solid phase foaming agent (part by weight) | | 5 | 5 | 5 | 5 | 5 | 5 |
| Inert gas (1/min) | | 2 | 2 | 2 | 2 | 2 | 2 |

[Table 2]

| | | C. Ex. 1 | C. Ex. 2 | C. Ex. 3 | C. Ex. 4 | C. Ex. 5 | C. Ex. 6 |
|---|---|---|---|---|---|---|---|
| Urethane-based pre-polymer | NCO% (%) | 8 | 8 | 8 | 8 | 8 | 8 |
| | Content (part by weight) | 100 | 100 | 100 | 100 | 100 | 100 |
| Curing agent (part by weight) | MOCA | 70 | 80 | 86 | - | - | - |
| | DMTDA | - | - | - | 70 | 80 | 86 |
| Surfactant (part by weight) | | 5 | 5 | 5 | 5 | 5 | 5 |
| Solid phase foaming agent (part by weight) | | 5 | 5 | 5 | 5 | 5 | 5 |
| Inert gas (1/min) | | 2 | 2 | 2 | 2 | 2 | 2 |

**Test** Example 1: Hardness

The polishing layers of Examples 1 to 6 and Comparative Examples 1 to 6 were each measured for hardness. Specifically, each polishing layer was cut to a thickness of 2 mm, a length of 5 cm, and a width of 5 cm and stored at 25°C for 12 hours. A hardness meter was used to measure the Shore D hardness thereof.

**Test Example 2: Elongation**

The polishing layers of Examples 1 to 6 and Comparative Examples 1 to 6 were each measured for elongation. Specifically, each polishing layer was cut to a thickness of 2 mm, a length of 4 cm, and a width of 1 cm and measured for the maximum deformation length immediately before fracture in a tensile test at a speed of 50 mm/minute using a universal test machine (UTM). The ratio of the maximum deformation length to the initial length was then obtained in a percentage (%).

**Test Example 3: TD-NMR**

The polishing layers of Examples 1 to 6 and Comparative Examples 1 to 6 were each measured for spin-lattice relaxation time (T1) and spin-spin relaxation time (T2) using TD-NMR.

Specifically, 10 g of each polishing layer was cut into pieces of 3 $mm^2$, and T1 and T2 were measured using TD-NMR (product name: mini-spec, manufacturer: Bruker) at room temperature (25°C). In such an event, T1 and T2 were calculated as the time taken to recover to 63% of the original equilibrium state.

**Test Example 4: Content of chlorine (Cl)**

The polishing layers of Examples 1 to 6 and Comparative Examples 1 to 6 were each measured for the content of chlorine. Specifically, a circular sample with a diameter of 3 cm and a height of 0.3 cm was prepared from each polishing layer. The content of chlorine in the sample was measured by IEC 62321-3-2, which is an international standard for measuring specific substances in a polymer by combustion-ion chromatography (C-IC).

**Test Example 5: Polishing rate (removal rate)**

The polishing pads of Examples 1 to 6 and Comparative Examples 1 to 6 were each fixed to the platen of CMP equipment, and a silicon wafer (diameter 300 mm) was set with the silicon oxide layer thereof facing downward. Then, a CMP process was carried out to measure the polishing rate.

Specifically, the silicon oxide layer was polished under a polishing load of 4.0 psi while the platen was rotated at a speed of 150 rpm for 60 seconds and a calcined ceria slurry was supplied onto the polishing pad at a rate of 250 ml/minute. Upon completion of the polishing, the silicon wafer was detached from the carrier, mounted in a spin dryer, washed with deionized water, and then dried for 15 seconds with nitrogen. The difference in the thickness of the silicon oxide layer in the dried silicon wafer before and after the polishing was measured using a spectral reflectometer-type thickness measuring instrument (model: SI-F80R, manufacturer: Keyence). The polishing rate was calculated according to the following Mathematical Equation 1.

[Mathematical Equation 1] Polishing rate (Å/min.) = difference in thickness before and after polishing (Å) / polishing time (min.)

**Test Example** 6: **Pad wear rate** (PWR)

The polishing pads of Examples 1 to 6 and Comparative Examples 1 to 6 were each measured for pad wear rate (PWR). Each polishing pad was mounted on the platen of CMP equipment, and the change in the thickness of the polishing layer was measured for 10 minutes while deionized water (DIW) was supplied at a rate of 150 ml/minute under the conditions of a platen rotation speed of 90 rpm, a conditioner rotation speed of 120 rpm, and a conditioner load of 6 psi.

[Table 3]

| | | | Ex. 1 | Ex. 2 | Ex. 3 | Ex. 4 | Ex. 5 | Ex. 6 |
|---|---|---|---|---|---|---|---|---|
| Polishing layer | Thickness (mm) | | 2 | 2 | 2 | 2 | 2 | 2 |
| | Hardness (Shore D) | | 58.8 | 60.0 | 61.0 | 56.9 | 58.0 | 59.8 |
| | Specific gravity (g/cc) | | 0.79 | 0.79 | 0.79 | 0.79 | 0.79 | 0.79 |
| | Elongation (%) | | 111 | 130 | 150 | 101 | 127 | 143 |
| | Cl content (ppm) | | 46,321 | 52,810 | 56,786 | 234 | 226 | 239 |
| Polishing pad | TD-NMR | T1 (ms) | 89.1 | 83.4 | 79.0 | 88.6 | 83.9 | 79.7 |
| | | T2 (ms) | 0.239 | 0.240 | 0.244 | 0.237 | 0.244 | 0.253 |
| | | Measurement temp. (°C) | 25 | 25 | 25 | 25 | 25 | 25 |
| | Polishing rate (Å/min.) | | 1,760 | 1,647 | 1,535 | 1,791 | 1,663 | 1,579 |
| | PWR (μm/10 minutes) | | 34.3 | 33.4 | 31.7 | 36.5 | 34.3 | 32.0 |

[Table 4]

| | | | C. Ex. 1 | C. Ex. 2 | C. Ex. 3 | C. Ex. 4 | C. Ex. 5 | C. Ex. 6 |
|---|---|---|---|---|---|---|---|---|
| Polishing layer | Thickness (mm) | | 2 | 2 | 2 | 2 | 2 | 2 |
| | Hardness (Shore D) | | 50.0 | 52.0 | 53.0 | 48.7 | 51.1 | 51.9 |
| | Specific gravity (g/cc) | | 0.79 | 0.79 | 0.79 | 0.79 | 0.79 | 0.79 |
| | Elongation (%) | | 130 | 150 | 170 | 119 | 138 | 152 |
| | Cl content (ppm) | | 40,234 | 45,426 | 46,839 | 289 | 275 | 246 |
| Polishing pad | TD-NMR | T1 (ms) | 82.6 | 78.9 | 76.7 | 81.7 | 78.6 | 76.5 |
| | | T2 (ms) | 0.187 | 0.194 | 0.203 | 0.188 | 0.196 | 0.208 |
| | | Measurement temp. (°C) | 25 | 25 | 25 | 25 | 25 | 25 |
| | Polishing rate (Å/min.) | | 1,590 | 1,463 | 1,379 | 1,587 | 1,428 | 1,392 |
| | PWR (μm/10 minutes) | | 32.5 | 29.3 | 27.0 | 34.5 | 32.1 | 29.8 |

As can be seen from Tables 1 and 2 above, the polishing pads of Examples 1 to 6 satisfied T1 and T2 of 100 ms or less and 0.21 ms or more, respectively, and the chlorine content, polishing rate, PWR, and other physical properties of the

polishing pads were all measured to be within the desirable ranges.

## Claims

1. A polishing pad, which comprises a polishing layer comprising a urethane-based prepolymer and a curing agent, wherein the polishing layer satisfies the following Relationships 1 and 2:

$$\text{[Relationship 1]} \qquad T1 \leq 100 \text{ ms}$$

$$\text{[Relationship 2]} \qquad T2 \geq 0.21 \text{ ms}$$

in Relationships 1 and 2, T1 is the spin-lattice relaxation time measured at 25°C using TD-NMR, and T2 is the spin-spin relaxation time measured at 25°C using TD-NMR.

2. The polishing pad of claim 1, wherein the polishing pad has a pad wear rate (PWR) of 40 μm/10 minutes or less when measured under the conditions of a platen rotation speed of 90 rpm, a conditioner rotation speed of 120 rpm, and a conditioner load of 6 psi at a deionized water (DIW) supplying rate of 150 ml/minute.

3. The polishing pad of claim 1, wherein the polishing layer has a content of chlorine (Cl) of 70,000 ppm or less when analyzed according to the IEC 62321-3-2 standard.

4. The polishing pad of claim 1, wherein when the polishing pad is used to polish the silicon oxide layer of a silicon wafer with a ceria slurry, the polishing rate according to the following Mathematical Equation 1 is 1,500 Å/minute to 6,000 Å/minute:

Polishing rate (Å/min.) = difference in thickness before and after polishing (Å) / polishing time (min.). [Mathematical Equation 1]

5. The polishing pad of claim 1, wherein the content of the curing agent is 60 parts by weight or more relative to 100 parts by weight of the urethane-based prepolymer.

6. The polishing pad of claim 1, wherein the curing agent comprises at least one selected from the group consisting of 4,4'-methylenebis(2-chloroaniline) (MOCA), diethyltoluenediamine (DETDA), 3,5-dimethylthio-2,6-diaminotoluene (DMTDA), 1,3-propanediol bis(4-aminobenzoate) (PDPAB), N,N'-bis(sec-butylamino)diphenylmethane, 2,6-bis(methylthio)-4-methyl-1,3-benzenediamine, 4-(4-aminobenzoyl)oxyphenyl 4-aminobenzoate, 4-(4-aminobenzoyl)oxybutyl 4-aminobenzoate, 4-[4-(4-aminobenzoyl)oxy-3-methylbutoxy]butyl 4-aminobenzoate, and methylene bis-methylanthranilate (MBNA).

7. The polishing pad of claim 1, wherein the urethane-based prepolymer has an isocyanate end group content (NCO%) of 5% by weight to 15% by weight.

8. The polishing pad of claim 1, wherein the polishing layer comprises a foaming agent,

   the foaming agent comprises at least one selected from the group consisting of an acrylonitrile-based copolymer, a methyl methacrylate-based copolymer, a methacrylonitrile-based copolymer, and an acrylic-based copolymer, and
   the content of the foaming agent is 0.1 part by weight to 5 parts by weight relative to 100 parts by weight of the urethane-based prepolymer.

9. The polishing pad of claim 1, wherein the polishing layer has a hardness of 55 Shore D to 70 Shore D, a tensile strength of 15 N/mm$^2$ to 25 N/mm$^2$, and an elongation of 90% to 150%.

10. A process for preparing a semiconductor device, which comprises polishing the surface of a semiconductor substrate using the polishing pad of claim 1.

[Fig. 1]

510
520
400
600
300
100
200

## INTERNATIONAL SEARCH REPORT

International application No.
**PCT/KR2024/017369**

**A. CLASSIFICATION OF SUBJECT MATTER**

**B24B 37/24**(2012.01)i; **H01L 21/321**(2006.01)i; **G01N 24/08**(2006.01)i; **C08G 18/32**(2006.01)i; **C08G 18/10**(2006.01)i; C08G 101/00(2006.01)n

According to International Patent Classification (IPC) or to both national classification and IPC

**B. FIELDS SEARCHED**

Minimum documentation searched (classification system followed by classification symbols)

B24B 37/24(2012.01); B24B 37/26(2012.01); B24D 3/28(2006.01); C08J 5/12(2006.01); H01L 21/304(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 우레탄계 프리폴리머(urethane prepolymer), 경화제(curing agent), 스핀-격자 이완시간(spin-lattice relaxation time), 스핀-스핀 이완 시간(spin-spin relaxation time), 연마층(polishing layer)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2129665 B1 (SKC CO., LTD.) 02 July 2020 (2020-07-02) See paragraphs [0003], [0004], [0121]-[0154], [0179] and [0180], table 2 and claim 1. | 1-10 |
| Y | JP 2013-094884 A (SUMITOMO BAKELITE CO., LTD.) 20 May 2013 (2013-05-20) See paragraphs [0006], [0007], [0023] and [0025]. | 1-10 |
| A | KR 10-1878814 B1 (FNS TECH CO., LTD.) 17 July 2018 (2018-07-17) See paragraphs [0061]-[0063]. | 1-10 |
| A | KR 10-2066002 B1 (SAMSUNG ELECTRONICS CO., LTD.) 11 February 2020 (2020-02-11) See paragraphs [0024]-[0030]. | 1-10 |
| A | JP 2017-121692 A (FNS TECH CO., LTD.) 13 July 2017 (2017-07-13) See paragraphs [0042]-[0044]. | 1-10 |

☐ Further documents are listed in the continuation of Box C.    ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **07 February 2025** | **10 February 2025** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.
**PCT/KR2024/017369**

| Patent document cited in search report | Publication date (day/month/year) | Patent family member(s) | Publication date (day/month/year) |
|---|---|---|---|
| KR 10-2129665 B1 | 02 July 2020 | KR 10-2020-0012112 A | 05 February 2020 |
| JP 2013-094884 A | 20 May 2013 | None | |
| KR 10-1878814 B1 | 17 July 2018 | KR 10-2018-0044771 A | 03 May 2018 |
| KR 10-2066002 B1 | 11 February 2020 | KR 10-2014-0144075 A | 18 December 2014 |
| | | US 2014-0364578 A1 | 11 December 2014 |
| | | US 9458280 B2 | 04 October 2016 |
| JP 2017-121692 A | 13 July 2017 | CN 106670990 A | 17 May 2017 |
| | | KR 10-1690996 B1 | 29 December 2016 |
| | | TW 201716181 A | 16 May 2017 |
| | | US 2017-0129072 A1 | 11 May 2017 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 20160027075